# EUROPÄISCHE PATENTANMELDUNG

(11) **EP 1 898 681 A1**
(43) Veröffentlichungstag der Anmeldung: **12.03.2008**
(21) Anmeldenummer: 07113619.6
(22) Anmeldetag: 01.08.2007
(51) Int. Cl.: H05K 1/14

(54) **Verfahren zum elektrischen Verbinden eines ersten Substrat mit einem zweiten Substrat**

(30) Priorität: 07.09.2006 DE 102006041983
(71) Anmelder: ROBERT BOSCH GMBH, 70442 Stuttgart (DE)
(72) Erfinder: Roethlingshoefer, Walter, 72766, Reutlingen (DE); Zipperer, Wilfried, 72760, Reutlingen (DE); Egerter, Juergen, 72766, Reutlingen (DE); Werner, Markus, 73779, Deizisau (DE)

(57) **Zusammenfassung**

Die Erfindung betrifft ein Verfahren zum elektrischen Verbinden eines ersten Substrats mit einem zweiten Substrat mittels Anschlüsse der Substrate verbindende Bondverbindungen, mit folgenden Schritten:
- Positionieren der Substrate aufeinander oder nebeneinander, sodass Zugang zu den Anschlüssen besteht,
- Erstellen der Bondverbindungen und
- Verändern der Relativlage der Substrate zueinander.

## Beschreibung

Die Erfindung betrifft ein Verfahren zum elektrischen Verbinden eines ersten Substrats mit einem zweiten Substrat mittels Anschlüsse der Substrate verbindenden Bondverbindungen.

### Stand der Technik

Es sind Verfahren bekannt, bei denen elektrische Anschlüsse zweier Substrate miteinander mittels Bondverbindungen elektrisch verbunden werden, wobei die Substrate so angeordnet werden, dass die elektrischen Anschlüsse in eine Richtung zeigen. Dabei wird ein hauchdünner Draht, der Bonddraht, durch eine Werkzeugspitze geführt und auf eine zu kontaktierende Fläche eines Anschlusses des einen Substrates gepresst und beispielsweise mittels eines kurzen Ultraschallimpulses mikroverschweißt. Anschließend wird die Werkzeugspitze zu der zweiten Kontaktierfläche eines Anschlusses des anderen Substrates bewegt, wobei Bonddraht durch die Werkzeugspitze nachgeführt wird. An der zweiten zu kontaktierenden Fläche wird der Bonddraht ebenfalls angepresst und beispielsweise mit einem Ultraschallimpuls mikroverschweißt. Dadurch ist die elektrische Verbindung von einem Anschluss eines Substrats mit einem Anschluss eines anderen Substrats hergestellt. Durch Entfernen des Werkzeugs beziehungsweise der Werkzeugspitze, ohne dass Bonddraht nachgeführt wird, reißt der Bonddraht ab und der Bondvorgang ist abgeschlossen. Während des gesamten Bondvorgangs liegen die Substrate auf einer Grundplatte, sodass der nötige Anpressdruck des Bondwerkzeugs aufgebracht werden kann.

Es sind auch Verbindungstechniken bekannt, wie zum Beispiel Flexfolienverbindungen, die zwar eine flexible Anordnung nach einem elektrischen Verbinden erlauben, jedoch aufgrund der hohen Kosten, insbesondere bei einer relativ geringen Anzahl benötigter elektrischer Verbindungen, nicht attraktiv sind.

### Offenbarung der Erfindung

Erfindungsgemäß werden die Substrate zunächst aufeinander oder nebeneinander so positioniert, dass Zugang zu den auf den Substraten befindlichen elektrischen Anschlüssen besteht, anschließend werden die Bondverbindungen erstellt, und abschließend wird die Relativlage der Substrate zueinander verändert. Dadurch können zusätzliche Freiheiten bei der Anordnung der Substrate ermöglicht werden, die bei den beengten Platzverhältnissen im Gehäuse eines elektrischen Geräts generell herrschen und auch in Zukunft verstärkt auftreten werden. Durch die Veränderung der Relativlage der Substrate zueinander, nach dem Erstellen der Bondverbindungen, werden erheblich mehr Anordnungen, insbesondere platzsparende Anordnung von Substraten im Gehäuse, ermöglicht. Da die Relativlage der Substrate erst nach dem Erstellen der Bondverbindungen verändert wird, kann so zum Erstellen der Bondverbindung vorteilhafterweise ein aus dem Stand der Technik bekanntes Verfahren verwendet werden, mittels dessen auf übliche Art und Weise die Bondverbindungen erstellt werden. Sicherlich wäre es auch möglich die Bondverbindungen zu erstellen, nachdem die Relativlage der Substrate zueinander verändert wurde. Jedoch wäre der Aufwand um ein Vielfaches größer, da das Bondwerkzeug eine wesentlich kompliziertere Bewegung ausüben können müsste und mindestens ein weiteres Werkzeug notwendig wäre, um ein oder beide Substrate gegen den Anpressdruck des Bondwerkzeugs zu stützen.

Vorteilhafterweise werden dazu die Substrate so positioniert, dass Zugang zu den Anschlüssen von einer Seite besteht, beziehungsweise dass die Anschlüsse in eine Richtung zeigen. So ist eine besonders einfache Bewegung für das Bondwerkzeug ermöglicht, insbesondere wenn außerdem die zu verbindenden Anschlüsse der Substrate vorteilhafterweise im Wesentlichen in einer Ebene oder in zumindest parallel zueinander ausgerichteten Ebenen angeordnet sind.

Vorteilhafterweise werden die Bondverbindung im Wesentlichen parallel zueinander erstellt. Die mit einem Bonddraht erstellten Bondverbindungen liegen also im Wesentlichen parallel zueinander, wobei kleine Abweichungen durchaus möglich sind. Zum einen ist dadurch das Erstellen der Bondverbindungen einfacher beziehungsweise kostengünstiger, und zum anderen werden die Bondverbindungen, wenn vorteilhafterweise das erste Substrat in Längsrichtung der Bondverbindungen gekippt wird, im Wesentlichen jeweils auf die gleiche Art und Weise beansprucht und verformt.

Vorteilhafterweise wird das erste Substrat in Längsrichtung der Bondverbindungen und/oder senkrecht zu dem zweiten Substrat versetzt, wobei es beispielsweise näher an das zweite Substrat oder weiter weg von dem zweiten Substrat gesetzt wird, um eine besonders vorteilhafte Anordnung in Bezug auf die nötigen Platzverhältnisse und/oder die Belastbarkeit beziehungsweise die Belastung der Bondverbindungen zu realisieren. Ebenso kann es senkrecht zu dem zweiten Substrat versetzt werden, so dass es auf einer Ebene höher oder tiefer als in seiner Ausgangsposition, vor dem Verändern der Relativlage, angeordnet wird.

Vorteilhafterweise werden die Bondverbindungen mit mindestens einer Krümmung erstellt, sodass beim Verändern der Relativlage der Substrate die Krümmung die Richtung der Verformung der Bondverbindungen bei einer Veränderung der Relativlage der Substrate zueinander vorgibt.

Nach einer Weiterbildung der Erfindung wird das erste Substrat so gekippt, dass es senkrecht zu dem zweiten Substrat steht. Dies hat zwei Vorteile, zum einen ist dies die platzsparendste Anordnung der Substrate, und zum anderen kann das erste Substrat durch das Kippen auf eine Seitenfläche, die vorteilhafterweise senkrecht zu den Anschlüssen auf dem Substrat ausgerichtet ist, einfach gestellt werden.

Vorteilhafterweise werden die Bondverbindungen beim Verändern der Relativlage des ersten Substrats zum zweiten Substrat elastisch/plastisch verformt. Die zumindest teilweise plastische Verformung der Bondverbindungen beziehungsweise des Bonddrahtes reduziert die Kräfte, die an den Verbindungsstellen beziehungsweise den Kontaktstellen zwischen den Bonddrähten und den Anschlüssen der Substrate herrschen, sodass diese sich auch unter hoher Beanspruchung, wie beispielsweise durch Vibrationen, Schlageinwirkungen und/oder Temperaturveränderungen nicht lösen und einen dauerhaften Kontakt gewährleisten.

Nach einer Weiterbildung der Erfindung wird das erste Substrat nach dem Verändern der Relativlage befestigt, wobei es bevorzugt an dem zweiten Substrat und/oder an einer Grundplatte auf die das erste und das zweite Substrat gelegt sind, befestigt wird. Die Grundplatte kann dabei auch von einem dritten Substrat gebildet werden.

Vorteilhafterweise wird das erste Substrat mittels Kleben an dem zweiten Substrat oder der Grundplatte befestigt. Das Kleben stellt dabei eine besonders einfache und kostengünstige Möglichkeit zum Befestigen dar. Bevorzugt wird dafür ein Epoxydharz-Kleber verwendet.

Nach einer Weiterbildung der Erfindung wird das erste Substrat zum Befestigen in eine Aufnahme gesteckt. Die Aufnahme weist dabei vorteilhafterweise eine Nut mit einem Querschnitt auf, der im Wesentlichen dem Querschnitt des ersten Substrats entspricht, und ist entweder vorzugsweise als ein Aufnahmeelement auf dem zweiten Substrat oder der Grundplatte angeordnet, oder besonders vorteilhafterweise in dem zweiten Substrat oder der Grundplatte direkt ausgebildet. Um einen besseren Halt zu gewährleisten, wird das erste Substrat in der Aufnahme zusätzlich, insbesondere mit einem Epoxydharz-Kleber, festgeklebt.

Ein weiterer Vorteil des erfindungsgemäßen Verfahrens liegt darin, dass wenn das erste Substrat auf der den mit Bondverbindungen versehenen Anschlüssen gegenüberliegenden Seite Anschlüsse für beispielsweise einen Stecker aufweist, der auf das erste Substrat gesteckt wird, die senkrechte Stellung des ersten Substrats bewirkt, dass der Stecker problemlos auf das erste Substrat gesteckt werden kann, da die das Zusammenstecken benötigte Kraft direkt gegen das zweite Substrat oder die Grundplatte wirkt, sodass die Bondverbindungen oder eventuelle andere elektrische Verbindungen nicht belastet werden.

### Kurze Beschreibung der Zeichnungen

Im Folgenden soll die Erfindung anhand von drei Zeichnungen näher erläutert werden. Dazu zeigen die
- Figur 1: zwei Substrate in einer perspektivischen Darstellung, deren Anschlüsse mittels Bondverbindungen verbunden sind,
- Figur 2: die zwei Substrate in einer perspektivischen Darstellung in einer veränderten Relativlage zueinander, und
- Figur 3: Schritte des erfindungsgemäßen Verfahrens in einem Flussdiagramm.

### Ausführungsform(en) der Erfindung

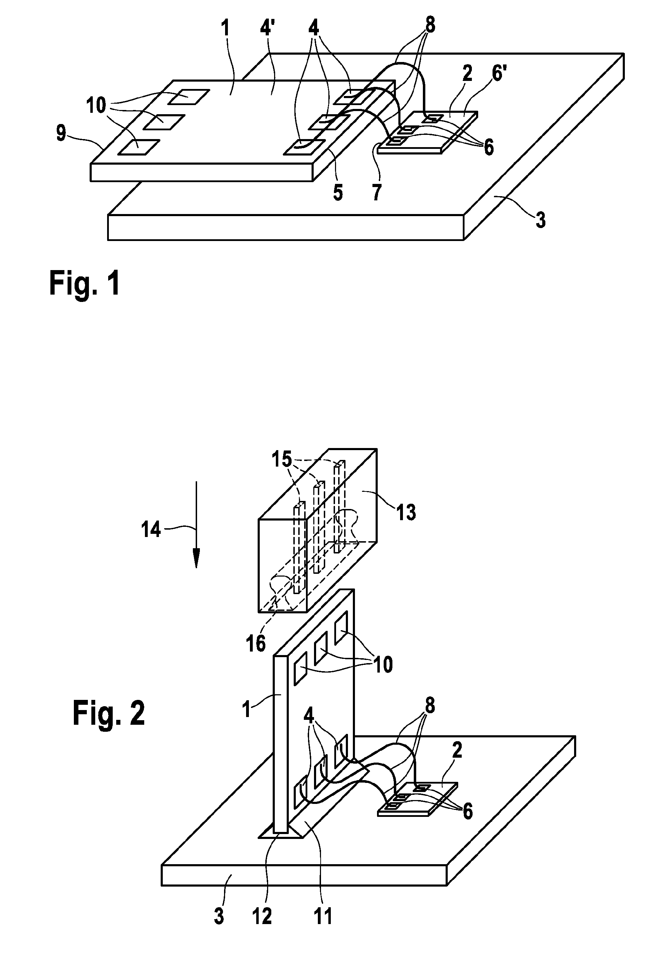

Die Figur 1 zeigt beispielhaft ein erstes Substrat 1 und ein zweites Substrat 2, die beide eine im wesentlichen rechteckförmige Kontur aufweisen und nebeneinander auf einer Grundplatte 3 angeordnet sind. Das erste Substrat 1 ist dabei wesentlich größer ausgebildet als das zweite Substrat 2. Das erste Substrat weist drei Anschlüsse 4 auf, die in einer Reihe parallel zu einer Seitenkante 5 des Substrats 1 auf einer Oberfläche 4' des Substrats 1 angeordnet sind. Das zweite Substrat 2 weist ebenfalls drei Anschlüsse 6 auf, die auf einer Oberfläche 6' des zweiten Substrats 2 angeordnet sind, von denen zwei parallel zu einer Seitenkante 7 des zweiten Substrats 2 in dessen Randbereich angeordnet sind, und von denen der dritte Anschluss 6 einen größeren Abstand zu der Seitenkante 7 als die beiden anderen Anschlüsse 6 aufweist. Das erste Substrat 1 und das zweite Substrat 2 sind so positioniert, dass die Seitenkanten 5 und 7 parallel und beabstandet zueinander angeordnet sind. Von einem Anschluss 4 führt jeweils ein eine Bondverbindung realisierender Bonddraht 8 zu einem Anschluss 6 des zweiten Substrats 2. Die Bonddrähte 8 sind dabei aufgrund der Anordnung der Substrate 1, 2 und der Anschlüsse 4, 6 im Wesentlichen parallel zueinander ausgerichtet. Die durch die Bonddrähte 8 erstellten Bondverbindungen werden beispielsweise mittels eines herkömmlichen Bondverfahrens, wie zum Beispiel Ultraschalldrahtbonden, erstellt. Dabei wird zunächst ein Ende des Bonddrahts 8 an einer Nadelspitze eines Bondwerkzeugs auf die, durch einen der Anschlüsse 4 oder 6 gebildete Kontaktfläche gepresst und mittels eines kurzen Ultraschallimpulses mikroverschweißt. Anschließend wird die Nadel des Bondwerkzeugs zu einer Kontaktfläche eines Anschlusses 6 oder 4 des zweiten Substrates geführt, wobei Bonddraht 8 durch das Werkzeug nachgeführt wird, und dort ebenfalls auf die Kontaktfläche gepresst und mittels eines Ultraschallimpulses mikroverschweißt. Somit ist eine elektrische Verbindung zwischen zwei Anschlüssen 4, 6 hergestellt. Durch Entfernen der Nadel des Bondwerkzeugs, wobei der Bonddraht abreißt, da kein weiterer Draht nachgeführt wird, wird der Bondvorgang abgeschlossen. Natürlich sind auch andere bekannte Bondverfahren verwendbar. Das erste Substrat 1 weist im Bondbereich der der Seitenkante 5 gegenüberliegenden Seitenkante 9 in einer Reihe angeordnete Anschlüsse 10 parallel zur Seitenkante 9 auf, die beispielsweise als Anschlusskontakte für einen in der Figur 1 nicht dargestellten Stecker dienen.

Die Figur 2 zeigt wiederum in einer perspektivischen Darstellung das erste Substrat 1 und das zweite Substrat 2 sowie die Grundplatte 3 aus der Figur 1 in einer beispielhaften, durch eine vorteilhafte Veränderung der Relativlage entstandenen Anordnung, wobei das erste Substrat 1 senkrecht zu dem zweiten Substrat 2 auf der Grundplatte 3 angeordnet ist. Auf der Oberfläche der Grundplatte 3 ist dabei ein Aufnahmeelement 11 angeordnet, das eine nutförmige Aussparung 12 aufweist, in die das erste Substrat 1 eingesteckt ist. Das Aufnahmeelement 11 wird dabei beispielsweise an der Grundplatte 3 durch Kleben befestigt. Die Bonddrähte 8 weisen aufgrund der Veränderung der Relativlage des ersten Substrats 1 einen stärker gekrümmten Verlauf auf als in der Figur 1. Vorteilhafterweise werden die Bonddrähte 8 durch das Senkrechtstellen des ersten Substrats 1 elastisch/plastisch verformt, sodass auf die Verbindungsstellen mit den Anschlüssen 4 oder 6 keine zu großen Kräfte wirken, die ein Abreißen der Bondverbindung beziehungsweise der Bonddrähte 8 von den Anschlüssen 4 oder 6 bewirken würden. Im Vergleich zu der in Figur 1 dargestellten Anordnung der Substrate 1 und 2 weist das erste Substrat 1 in der Figur 2 einen größeren Abstand zu dem zweiten Substrat 2 auf. Das erste Substrat wird also nicht nur gekippt, sondern auch versetzt zu dem zweiten Substrat 2 angeordnet. Dies trägt auch dazu bei, dass die Belastung in den Schweißverbindungen der Bonddrähte 8 mit den Anschlüssen 4 oder 6 reduziert werden, und dass die Substrate 1, 2 noch platzsparender angeordnet werden.

Beabstandet zu dem ersten Substrat 1 ist ein Stecker 13 so angeordnet, dass, wenn er in Richtung des Pfeils 14 senkrecht zu der Grundplatte 3 bewegt wird, mit den Anschlüssen 10 des ersten Substrats 1 in Kontakt tritt. Dazu sind in dem Stecker 13 drei Kontaktstifte 15 angeordnet, die beim Zusammenstecken direkt mit den Anschlüssen 10 in Berührungskontakt treten. Des weiteren weist der Stecker 13 eine Aufnahmefeder 16 auf, in die das erste Substrat 1 geführt wird, und welche aufgrund einer Eigenelastizität das erste Substrat 1 festklemmt, sodass der Stecker 13 sich nicht von selbst von dem Substrat 1 lösen kann. Von dem Stecker 13 führt beispielsweise ein hier nicht dargestelltes Kabel zu weiteren elektrischen/elektronischen Komponente.

In einer alternativen Ausführungsform wird das erste Substrat 1 in eine Aussparung 12, die direkt in der Grundplatte 3 ausgebildet ist, gesteckt. In einer weiteren vorteilhaften Ausführungsform wird das erste Substrat 1 direkt auf die Grundplatte 3, vorzugsweise mit Epoxydharz-Kleber geklebt. In der in Figur 2 dargestellten Ausführungsform kann das erste Substrat 1 zusätzlich mittels Kleber, vorzugsweise mittels Epoxydharz-Kleber, in beziehungsweise an dem Aufnahmeelement 11 befestigt werden.

Die vorteilhaften Ausführungsformen des erfindungsgemäßen Verfahrens ermöglichen zusätzliche Freiheiten bei der Anordnung der Substrate 1, 2, was insbesondere vorteilhaft bei den beengten Platzverhältnissen ist, die heute in einem Gerätegehäuse eines elektrischen/elektronischen Gerätes herrschen, und auch in Zukunft verstärkt auftreten werden. Durch das erfindungsgemäße Verfahren kann eine vorteilhafte Anordnung sehr kostengünstig realisiert werden.

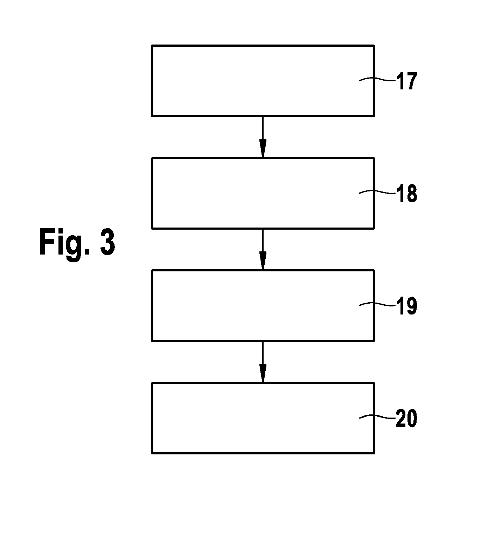

Die Figur 3 zeigt in einer schematischen Darstellung zusammengefasst die einzelnen Schritte des erfindungsgemäßen Verfahrens mit Bezug auf die Figuren 1 und 2. Zunächst werden in einem ersten Schritt 17 die Substrate 1, 2 aufeinander oder nebeneinander so positioniert, dass Zugang zu an den Substraten angeordneten elektrischen Anschlüssen 4, 6 besteht. Vorteilhafterweise werden die Substrate 1, 2 so angeordnet, dass Zugang zu den Anschlüssen 4, 6 von einer Seite besteht. In einem zweiten Schritt 18 werden die elektrischen Anschlüsse 4 6 der Substrate 1, 2 mittels üblicher Bondverbindungen elektrisch verbunden. Dies kann beispielsweise mittels eines Ultraschall-Drahtbond-Verfahrens geschehen. In einem dritten Schritt 19 wird die Relativlage der Substrate 1 2 zueinander verändert. Vorteilhafterweise wird dabei das Substrat 1 in eine senkrechte Position zu dem zweiten Substrat 2 gekippt und/oder versetzt. In einem vierten, abschließenden Schritt 20 wird das erste Substrat 1 beispielsweise auf der Grundplatte 3 in einem Aufnahmeelement 11 befestigt. Alternativ kann das erste Substrat 1 auch auf die Grundplatte 3 direkt geklebt werden, beispielsweise mittels einem Epoxydharz-Kleber. Ebenso kann das erste Substrat 1 im vierten Schritt 20 direkt oder über ein Aufnahmeelement 11 an dem zweiten Substrat 2 befestigt werden.

## Patentansprüche

1. Verfahren zum elektrischen Verbinden eines ersten Substrats mit einem zweiten Substrat mittels Anschlüsse der Substrate verbindenden Bondverbindungen, mit folgenden Schritten:
- Positionieren der Substrate aufeinander oder nebeneinander, sodass Zugang zu den Anschlüssen besteht,
- Erstellen der Bondverbindungen und
- Verändern der Relativlage der Substrate zueinander.

2. Verfahren nach Anspruch 1, **dadurch gekennzeichnet, dass** die Substrate so positioniert werden, dass Zugang zu den Anschlüssen von einer Seite besteht.

3. Verfahren nach einem der vorhergehenden Ansprüche, **dadurch gekennzeichnet, dass** die Bondverbindungen im Wesentlichen parallel zueinander erstellt werden.

4. Verfahren nach einem der vorhergehenden Ansprüche, **dadurch gekennzeichnet, dass** das erste Substrat in Längsrichtung der Bondverbindungen gekippt wird.

5. Verfahren nach einem der vorhergehenden Ansprüche, **dadurch gekennzeichnet, dass** das erste Substrat in Längsrichtung der Bondverbindungen und/oder senkrecht zu dem zweiten Substrat versetzt wird.

6. Verfahren nach einem der vorhergehenden Ansprüche, **dadurch gekennzeichnet, dass** die Bondverbindungen mit mindestens einer Krümmung erstellt werden.

7. Verfahren nach einem der vorhergehenden Ansprüche, **dadurch gekennzeichnet, dass** das erste Substrat senkrecht zu dem zweiten Substrat gekippt wird.

8. Verfahren nach einem der vorhergehenden Ansprüche, **dadurch gekennzeichnet, dass** die Bondverbindungen beim Verändern der Relativlage elastisch/plastisch verformt werden.

9. Verfahren nach einem der vorhergehenden Ansprüche, **dadurch gekennzeichnet, dass** das erste Substrat nach dem Verändern der Relativlage befestigt wird.

10. Verfahren nach einem der vorhergehenden Ansprüche, **dadurch gekennzeichnet, dass** das erste Substrat an dem zweiten Substrat befestigt wird.

11. Verfahren nach einem der vorhergehenden Ansprüche, **dadurch gekennzeichnet, dass** das erste und das zweite Substrat an einer Grundplatte befestigt werden.

12. Verfahren nach einem der vorhergehenden Ansprüche, **dadurch gekennzeichnet, dass** das erste Substrat mittels Kleben befestigt wird.

13. Verfahren nach einem der vorhergehenden Ansprüche, **dadurch gekennzeichnet, dass** zum Kleben ein Epoxydharz verwendet wird.

14. Verfahren nach einem der vorhergehenden Ansprüche, **dadurch gekennzeichnet, dass** das erste Substrat zum Befestigen in eine Aufnahme gesteckt wird.
